# EUROPEAN PATENT SPECIFICATION

(11) **EP 3 573 197 B1**
(45) Date of publication and mention of the grant of the patent: **07.09.2022**
(21) Application number: 17907336.6
(22) Date of filing: 19.07.2017
(51) Int. Cl.: H01R 27/00, H01R 27/02, H01R 31/06, H01R 24/60, G06F 1/16

(54) **POWER DATA DOCKING STATION HAVING DOUBLE INTERFACES CAPABLE OF BEING FORWARDLY/REVERSELY PLUGGED**
LEISTUNGSDATENANDOCKSTATION MIT DOPPELSCHNITTSTELLEN, DIE VORWÄRTS/UMGEKEHRT ANGESCHLOSSEN WERDEN KÖNNEN
STATION D'ACCUEIL DE DONNÉES ET D'ALIMENTATION COMPORTANT DES INTERFACES DOUBLES POUVANT ÊTRE BRANCHÉES VERS L'AVANT/VERS L'ARRIÈRE

(30) Priority: 27.04.2017 CN 201720469643 U
(43) Date of publication of application: 27.11.2019
(73) Proprietor: Guangdong Gopod Group Co., Ltd., Shenzhen, Guangdong 518108 (CN)
(72) Inventor: LIAO, Zhuowen, Shenzhen Guangdong 518108 (CN)
(74) Representative: Ipside
(86) International application number: PCT/CN2017/093572
(87) International publication number: WO 2018/196180

(56) References cited:
- CN-A- 106 025 742
- CN-U- 204 179 435
- CN-U- 204 179 435
- CN-U- 205 159 722
- CN-U- 205 378 079
- CN-U- 206 135 140
- DE-U1-202014 100 336
- US-A1- 2014 013 024

## Description

### Technical Field

The present invention belongs to the technical field of integrated design for charging and data transmission, and more particularly, relates to a dual-interface reversible plug-in power source and data docking station.

### Background Art

In recent years, with rapid development of electronic technology and integrated circuit application design, charging and data products have become field application products for consumer groups. The power source and data docking station is a design application that can be implemented to simultaneously complete charging and data communication between digital products, so that devices become more and more compatible among application fields. However, existing power source and data docking stations still have the following problem: the power source and data docking station is only provided with one Type-C interface for data transmission, and if the power source and data docking station is connected to one of interfaces of a MacbookPro (an Apple's product) through the Type-C interface (i.e., a common USB Type-C interface), it will block the other interface of the MacbookPro, so that one interface of the MacbookPro is not fully usable.

Patent document CN204179435U describes an expansion module provided with a USB C-Type connector. The expansion module comprises a circuit board, a concentrator IC, a signal processing IC, a USB C-Type connector male head and a plurality of expansion connectors.

Document DE202014100336U1 describes a port replicator applicable to an electronic device having one or more connecting port and includes a shell including an abutting portion and an extending portion connected with each other and a replicating circuit module.

### Technical Problem

An object of the present invention is to provide a dual-interface reversible plug-in power source and data docking station, which aims to solve the problem of failing to fully utilize two interfaces of a MacbookPro when the existing power source and data docking station is connected to an interface of the MacbookPro.

### Technical Solutions

A dual-interface reversible plug-in power source and data docking station according to the invention is disclosed in independent claim 1. Other aspects of the invention are disclosed in the dependent claims.

### Beneficial Effects

The beneficial effects of the dual-interface reversible plug-in power source and data docking station provided by the invention are as follows: compared with the prior art, when the dual-interface reversible plug-in power source and data docking station described above is configured to be connected to a MacbookPro, the first Type-C male interface and the second Type-C male interface located on the first side of the circuit board can be respectively connected to the two interfaces of the MacbookPro, and the first Type-C male interface and the second Type-C male interface can be connected to the two interfaces of the MacbookPro regardless of whether normal plug-in or reverse plug-in is used; and moreover, since the two interfaces of the MacbookPro are blocked by the dual-interface reversible plug-in power source and data docking station so that user cannot use the two original interfaces of the MacbookPro for charging, video communication or data communication, the dual-interface reversible plug-in power source and data docking station is provided with the first Type-C female interface and the second Type-C female interface for extension while converting the first Type-C male interface and the second Type-C male interface into other interfaces such as the interface group, and is externally connected to an external electronic product through the first Type-C female interface and the second Type-C female interface for charging, video communication or data communication. In this way, when the dual-interface reversible plug-in power source and data docking station described above is used by a user for charging, video communication or data communication for an external electronic product, it not only has a new Type-C female interface function and is also compatible with the old interface function, e.g., using the interface group.

### Brief Description of the Drawings

In order to illustrate the technical solutions in the embodiments of the present invention more clearly, a brief introduction to the figures to be used in the description of the embodiments or the prior art will be provided below.
Fig. 1 is exploded structural schematic diagram I of a dual-interface reversible plug-in power source and data docking station provided by an embodiment of the present invention;
Fig. 2 is exploded structural schematic diagram II of a dual-interface reversible plug-in power source and data docking station provided by an embodiment of the present invention; and
Fig. 3 is exploded structural schematic diagram III of a dual-interface reversible plug-in power source and data docking station provided by an embodiment of the present invention.

In the figures, reference numerals in the figures:
10 - dual-interface reversible plug-in power source and data docking station; 11 - case; 12 - circuit board; 131 - first Type-C male interface; 132 - second Type-C male interface; 141 - first Type-C female interface; 142 - second Type-C female interface; 15 - interface group; 16 - opening; 151 - USB interface; 152 - HDMI interface; 153 - SD card interface; 154 - Micro SD card interface; 111 - bottom case; 112 - upper cover; 17 - fixing frame; 171 - notch; 1121 - barb; and 172 - barb slot.

### Detailed Description of Embodiments

In order to make the technical problems to be solved, the technical solutions and the beneficial effects of the present invention clearer, the present invention is further illustrated in detail below in conjunction with the accompanying drawings and embodiments. It should be understood that the specific embodiments described here are merely illustrative of the present invention but are not intended to limit the present invention.

It should be noted that when an element is referred to as being "fixed to" or "arranged at" a further element, it can be directly located on the further element or indirectly located on the further element. When an element is referred to as being "connected to" a further element, it can be directly connected to the further element or indirectly connected to the further element.

It should be understood that orientation or positional relationship indicated by the terms "length", "width", "upper", "lower", "front", "rear", "left", "right", "vertical", "horizontal", "top", "bottom", "inside", "outside" and the like is based on the orientation or positional relationship as shown in the drawings, and is merely for the convenience of describing the present invention and simplifying the description, rather than indicating or implying that the indicated apparatus or element must have a particular orientation or be configured and operated in a particular orientation, which is thus not to be construed as limiting the present invention.

In addition, the terms "first" and "second" are for descriptive purposes only and should not be understood as indicating or implying relative importance or implicitly indicating the number of technical features indicated. Thus, the features defined with "first" and "second" can explicitly or implicitly include one or more of the features. In the description of the present invention, the meaning of "a plurality of' is two or more unless clearly and specifically defined otherwise.

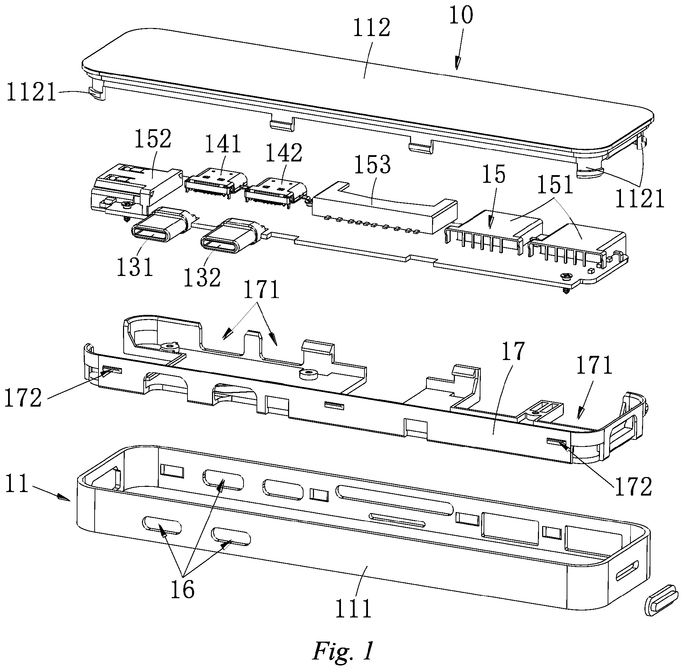

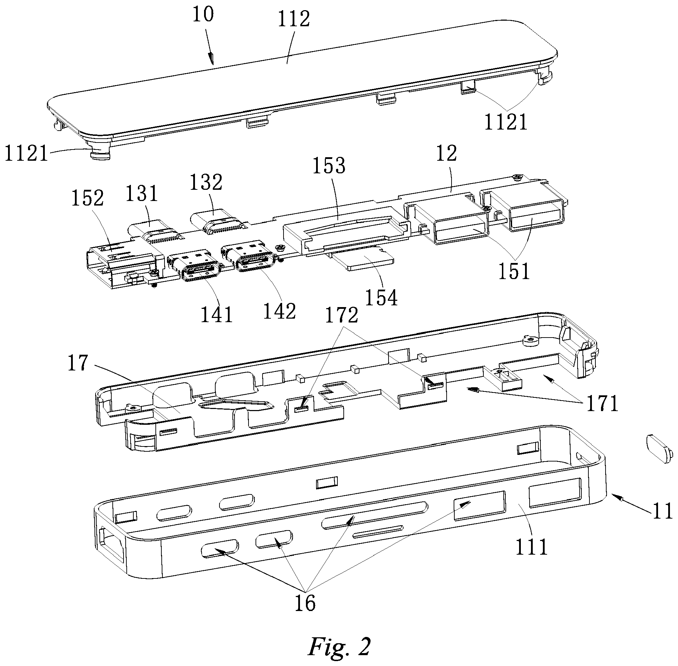

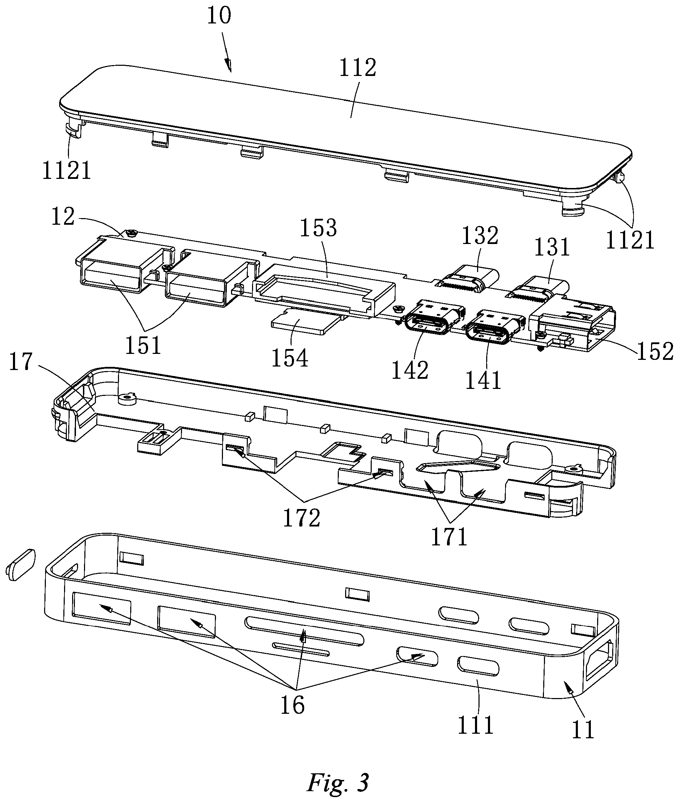

Referring to Figs. 1 to 3 together, the present invention provides a dual-interface reversible plug-in power source and data docking station 10, comprising a case 11 having an inner cavity and a circuit board 12 arranged in the inner cavity, wherein the circuit board 12 is provided with a first side and a second side opposite to or adjacent to the first side; the first side is provided with a first Type-C male interface 131 configured to be connected to one of interfaces of the MacbookPro and a second Type-C male interface 132 which are arranged side by side at an interval from the first Type-C male interface 131 and configured to be connected to the other interface of the MacbookPro; the second side is provided with a first Type-C female interface 141 and a second Type-C female interface 142 respectively opposite to the first Type-C male interface 131 and the second Type-C male interface 132, the second side is further provided with an interface group 15 for charging and/or data transmission for an external electronic product, and the first Type-C male interface 131 and the second Type-C male interface 132 are exposed outside the case 11; and the case 11 is provided with a plurality of openings 16 respectively corresponding to the first Type-C female interface 141, the second Type-C female interface 142 and the interface group 15 on a one-to-one correspondence basis.

Referring to Figs. 1 to 3 together, when the dual-interface reversible plug-in power source and data docking station 10 described above is configured to be connected to a MacbookPro, the first Type-C male interface 131 and the second Type-C male interface 132 located on the first side of the circuit board 12 can be respectively connected to the two interfaces of the MacbookPro, and the first Type-C male interface 131 and the second Type-C male interface 132 can be connected to the two interfaces of the MacbookPro regardless of whether normal plug-in or reverse plug-in is used Moreover, since the two interfaces of the MacbookPro are blocked by the dual-interface reversible plug-in power source and data docking station 10 so that the user cannot use the two original interfaces of the MacbookPro for charging, video communication or data communication, the dual-interface reversible plug-in power source and data docking station 10 is provided with the first Type-C female interface 141 and the second Type-C female interface 142 for extension while converting the first Type-C male interface 131 and the second Type-C male interface 132 into other interfaces such as the interface group 15, and is externally connected to an external electronic product through the first Type-C female interface 141 and the second Type-C female interface 142 for charging, video communication or data communication. In this way, when the dual-interface reversible plug-in power source and data docking station 10 described above is used by a user for charging, video communication or data communication for an external electronic product, it not only has a new Type-C female interface function and is also compatible with the old interface function, e.g., using the interface group 15.

It should be additionally noted that the first Type-C male interface 131, the second Type-C male interface 132, the first Type-C male interface 131 and the second Type-C male interface 132 are all in bidirectional transmission; the first Type-C female interface 141 is configured to be connected to a device with Type-C interfaces and support USB data transmission; and the second Type-C female interface 142 is configured to be connected to the device with Type-C interfaces and support PD charging function, USB data transmission and DP data transmission (DisplayPort, which is a high-definition digital display interface standard, referred to as DP for short).

Referring to Figs. 1 to 3 together, in order to implement the function extension of the dual-interface reversible plug-in power source and data docking station 10 in a better way, the interface group 15 comprises a USB interface 151, an HDMI interface 152 (High Definition Multimedia Interface, 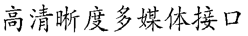 as the Chinese name, referred to as HDMI for short) configured to be connected to a display device, an SD card interface 153 for reading an SD card (SecureDigital, referred to as SD for short), and a Micro SD card interface 154 for reading a Micro SD card. Of course, the number of USB interfaces 151 is set to at least one. The type of the USB interface 151 may be USB2.0, USB3.0, USB-C or USB3.1 Gen1^{∗}2, and when the USB interface 151 is USB3.1 Gen1^{∗}2, it supports 5Gb high-speed transmission. Thus, a mobile phone, a tablet or a PC computer may be connected through the USB interface 151; a display device, such as a high-definition display, is connected through the HDMI interface 152, specifically, the HDMI interface 152 supports HDMI 2.0a and supports 4K/30Hz resolution; and the information of an SD card is read through the SD card interface 153, of course, the SD card includes a Micro SD card.

Specifically, the case 11 comprises a bottom case 111, and the bottom case 111 comprises a bottom portion and a side wall extending along the periphery of the bottom portion, the bottom portion and the side wall are enclosed to form the inner cavity, an upper end of the side wall is detachably connected to an upper cover 112, and the openings 16 are provided in the side wall.

Referring to Figs. 1 to 3 together, in order to facilitate installing and fixing the circuit board 12 into the inner cavity, a fixing frame 17 is arranged in the inner cavity, and the circuit board 12 is installed on the fixing frame 17.

Specifically, in order to allow the circuit board 12 to be installed and fixed to the fixing frame 17 in a better way, the fixing frame 17 comprises a bottom plate and a side frame wall extending along the periphery of the bottom plate, and the side frame wall is provided with a plurality of notches 171 respectively corresponding to the opening 16 on a one-to-one correspondence basis, and the circuit board 12 is installed in a space enclosed by the bottom plate and the side frame wall.

Referring to Figs. 1 to 3 together, specifically, in order to assemble and disassemble the case 11 more conveniently, the periphery of the upper cover 112 is provided with a plurality of barbs 1121 arranged at intervals, and the side frame wall is provided with a plurality of barb slots 172 respectively corresponding to and matching the barbs 1121 on a one-to-one correspondence basis. Thus, the assembly and disassembly between the bottom case 111 and the upper cover 112 is achieved by the matching between the barbs 1121 and the barb slots 172.

In order to make full use of the installation space on the circuit board 12, the circuit board 12 has an elongated shape, the first side is arranged opposite the second side, the first Type-C female interface 141, the second Type-C female interface 142 and the interface group 15 are all arranged on the second side, and the case 11 has an elongated shape. Thus, the dual-interface reversible plug-in power source and data docking station 10 described above can be made small in size and integrates multiple functions of charging and data communication.

Referring to Figs. 1 to 3 together, in order to facilitate the implementation of charging and data communication functions of the dual-interface reversible plug-in power source and data docking station 10 described above, a main control chip, a high-definition decoding chip, a power source management chip, a high-frequency transformer and a power component are arranged at intervals on the circuit board 12.

In order to further implement the function extension of the dual-interface reversible plug-in power source and data docking station 10 described above, the interface group 15 further comprises a VGA interface (Video Graphics Array, referred to as VGA for short), a DVI interface (Digital Visual Interface, referred to as DVI for short), a DP interface (DisplayPort, which is a high-definition digital display interface standard, referred to as DP for short), a Mini DP interface (English: Mini DisplayPort, which is a high-definition digital display interface standard , referred to as small DP for short) or a network interface.

## Claims

1. A dual-interface reversible plug-in power source and data docking station (10), comprising a case (12) having an inner cavity and a circuit board (12) arranged in the inner cavity, wherein that the circuit board (12) is provided with a first side and a second side opposite or adjacent to the first side; the first side is provided with a first Type-C male interface (131) configured to be connected to a first interface of a MacbookPro, and a second Type-C male interface (132) which is arranged side by side at an interval from the first Type-C male interface (131) and configured to be connected to a second interface, adjacent to the first interface, of the MacbookPro; the second side is provided with a first Type-C female interface (141) and a second Type-C female interface (142) which are respectively opposite the first Type-C male interface and the second Type-C male interface (132), and the second side is further provided with an interface group (15) for charging and/or data transmission for an external electronic product; the first Type-C male interface and the second Type-C male interface are exposed outside the case (12); and the case is provided with a plurality of openings (16) respectively corresponding to the first Type-C female interface, the second Type-C female interface and the interface group (15) on a one-to-one correspondence basis,
further wherein the first Type-C female interface (141) is connected to a device with Type-C interfaces and configured to support USB data transmission, and the second Type-C female interface (142) is connected to the device with Type-C interfaces and configured to support a PD charging function.

2. The dual-interface reversible plug-in power source and data docking station (10) of claim 1, **characterized in that** the interface group (15) comprises a USB interface, an HDMI interface configured to be connected to a display device, an SD card interface for reading an SD card, and a Micro SD card interface for reading a Micro SD card.

3. The dual-interface reversible plug-in power source and data docking station (10) of claim 1, **characterized in that** the case (12) comprises a bottom case (111), which comprises a bottom portion and a side wall extending along the periphery of the bottom portion, wherein the bottom portion and the side wall are enclosed to form the inner cavity, an upper end of the side wall is detachably connected to an upper cover (112), and the openings (16) are provided in the side wall.

4. The dual-interface reversible plug-in power source and data docking station (10) of claim 3, **characterized in that** a fixing frame (17) is arranged in the inner cavity, and the circuit board (12) is installed on the fixing frame.

5. The dual-interface reversible plug-in power source and data docking station (10) of claim 4, **characterized in that** the fixing frame (17) comprises a bottom plate and a side frame wall extending along the periphery of the bottom plate, wherein the side frame wall is provided with a plurality of notches (171) respectively corresponding to the opening (16) on a one-to-one correspondence basis, and the circuit board (12) is installed in a space enclosed by the bottom plate and the side frame wall.

6. The dual-interface reversible plug-in power source and data docking station (10) of claim 5, **characterized in that** the periphery of the upper cover (112) is provided with a plurality of barbs (1121) arranged at intervals, and the side frame wall is provided with a plurality of barb slots (172) respectively corresponding to and matching the barbs (1121) on a one-to-one correspondence basis.

7. The dual-interface reversible plug-in power source and data docking station (10) according to any one of claims 2-6, **characterized in that** the number of the USB interfaces is set to at least one.

8. The dual-interface reversible plug-in power source and data docking station (10) according to any one of claims 1-6, **characterized in that** the case (12) has an elongated shape.

9. The dual-interface reversible plug-in power source and data docking station (10) according to any one of claims 1-6, **characterized in that** a main control chip, a high-definition decoding chip, a power source management chip, a high-frequency transformer and a power component are arranged at intervals on the circuit board (12).

10. The dual-interface reversible plug-in power source and data docking station (10) according to any one of claims 1-6, **characterized in that** the interface group (15) further comprises a VGA interface, a DVI interface, a DP interface, a Mini DP interface or a network interface.

11. The dual-interface reversible plug-in power source and data docking station (10) according to any one of claims 2-6, **characterized in that** the type of the USB interface is USB2.0, USB3.0, USB-C or USB3.1.

12. The dual-interface reversible plug-in power source and data docking station (10) according to any one of claims 1-6, **characterized in that** the first Type-C male interface (131), the second Type-C male interface (132), the first Type-C male interface and the second Type-C male interface are all in bidirectional transmission.

## Patentansprüche

1. Umschaltbare steckbare Doppel-Schnittstellen-Stromquelle und Daten-Dockingstation (10), ein Gehäuse (12) umfassend, das einen inneren Hohlraum aufweist und eine Leiterplatte (12), die im inneren Hohlraum angeordnet ist, wobei die Leiterplatte (12) mit einer ersten Seite versehen ist und einer zweiten Seite, die der ersten Seite gegenüberliegt oder benachbart ist; die erste Seite ist mit einer ersten Typ-C-Stiftschnittstelle (131) versehen, konfiguriert, um mit einer ersten Schnittstelle eines MacBookPro verbunden zu werden, und einer zweiten Typ-C-Stiftschnittstelle (132), die Seite an Seite in einem Abstand von der ersten Typ-C-Stiftschnittstelle (131) angeordnet ist und konfiguriert, um mit einer zweiten Schnittstelle des MacBookPro verbunden zu werden, die benachbart zur ersten Schnittstelle ist; die zweite Seite ist mit einer ersten Typ-C-Buchsenschnittstelle (141) und einer zweiten Typ-C-Buchsenschnittstelle (142) versehen, die jeweils der ersten Typ-C-Stiftschnittstelle und der zweiten Typ-C-Stiftschnittstelle (132) gegenüberliegen, und die zweite Seite ist ferner mit einer Schnittstellengruppe (15) zum Laden und/oder zur Datenübertragung für ein externes elektronisches Produkt versehen; die erste Typ-C-Stiftschnittstelle und die zweite Typ-C-Stiftschnittstelle liegen außerhalb des Gehäuses (12); und das Gehäuse ist mit einer Vielzahl von Öffnungen (16) versehen, die jeweils der ersten Typ-C-Buchsenschnittstelle, der zweiten Typ-C-Buchsenschnittstelle und der Schnittstellengruppe (15) auf einer Eins-zu-eins-Korrespondenzbasis entsprechen,
wobei ferner die erste Typ-C-Buchsenschnittstelle (141) mit einer Vorrichtung mit Typ-C-Schnittstellen verbunden ist und konfiguriert, um USB-Datenübertragung zu unterstützen, und die zweite Typ-C-Buchsenschnittstelle (142) ist mit der Vorrichtung mit Typ-C-Schnittstellen verbunden und konfiguriert, um eine PD-Ladefunktion zu unterstützen.

2. Umschaltbare steckbare Doppel-Schnittstellen-Stromquelle und Daten-Dockingstation (10) nach Anspruch 1, **dadurch gekennzeichnet, dass** die Schnittstellengruppe (15) eine USB-Schnittstelle umfasst, eine HDMI-Schnittstelle, konfiguriert, um mit einer Anzeigevorrichtung verbunden zu werden, eine SD-Kartenschnittstelle zum Lesen einer SD-Karte und eine Micro-SD-Kartenschnittstelle zum Lesen einer Micro-SD-Karte.

3. Umschaltbare steckbare Doppel-Schnittstellen-Stromquelle und Daten-Dockingstation (10) nach Anspruch 1, **dadurch gekennzeichnet, dass** das Gehäuse (12) einen Gehäuseboden (111) umfasst, der einen Bodenbereich umfasst und eine Seitenwand, die sich entlang des Umfangs des Bodenbereichs erstreckt, wobei der Bodenbereich und die Seitenwand umschlossen sind, um den inneren Hohlraum zu bilden, ein oberes Ende der Seitenwand lösbar mit einer oberen Abdeckung (112) verbunden ist und die Öffnungen (16) in der Seitenwand vorgesehen sind.

4. Umschaltbare steckbare Doppel-Schnittstellen-Stromquelle und Daten-Dockingstation (10) nach Anspruch 3, **dadurch gekennzeichnet, dass** ein Befestigungsrahmen (17) im inneren Hohlraum angeordnet ist und die Leiterplatte (12) auf dem Befestigungsrahmen montiert ist.

5. Umschaltbare steckbare Doppel-Schnittstellen-Stromquelle und Daten-Dockingstation (10) nach Anspruch 4, **dadurch gekennzeichnet, dass** der Befestigungsrahmen (17) eine Bodenplatte umfasst und eine Seitenrahmenwand, die sich entlang des Umfangs der Bodenplatte erstreckt, wobei die Seitenrahmenwand mit einer Vielzahl von Einschnitten (171) versehen ist, die jeweils der Öffnung (16) auf einer Eins-zu-eins-Korrespondenzbasis entsprechen und die Leiterplatte (12) in einem von der Bodenplatte und der Seitenrahmenwand umschlossenen Raum montiert ist.

6. Umschaltbare steckbare Doppel-Schnittstellen-Stromquelle und Daten-Dockingstation (10) nach Anspruch 5, **dadurch gekennzeichnet, dass** der Umfang der oberen Abdeckung (112) mit einer Vielzahl von Einrastnasen (1121) versehen ist, die in Abständen angeordnet sind, und die Seitenrahmenwand mit einer Vielzahl von Einrastschlitzen (172) versehen ist, die jeweils den Einrastnasen (1121) entsprechen und auf einer Eins-zu-eins-Korrespondenzbasis übereinstimmen.

7. Umschaltbare steckbare Doppel-Schnittstellen-Stromquelle und Daten-Dockingstation (10) nach einem der Ansprüche 2 bis 6, **dadurch gekennzeichnet, dass** die Anzahl der USB-Schnittstellen mindestens gleich eins ist.

8. Umschaltbare steckbare Doppel-Schnittstellen-Stromquelle und Daten-Dockingstation (10) nach einem der Ansprüche 1 bis 6, **dadurch gekennzeichnet, dass** das Gehäuse (12) eine längliche Form aufweist.

9. Umschaltbare steckbare Doppel-Schnittstellen-Stromquelle und Daten-Dockingstation (10) nach einem der Ansprüche 1 bis 6, **dadurch gekennzeichnet, dass** ein Hauptsteuerchip, ein hochauflösender Decodierchip, ein Stromquellen-Management-Chip, ein Hochfrequenztransformator und eine Leistungskomponente in Abständen auf der Leiterplatte (12) angeordnet sind.

10. Umschaltbare steckbare Doppel-Schnittstellen-Stromquelle und Daten-Dockingstation (10) nach einem der Ansprüche 1 bis 6, **dadurch gekennzeichnet, dass** die Schnittstellengruppe (15) ferner eine VGA-Schnittstelle umfasst, eine DVI-Schnittstelle, eine DP-Schnittstelle, eine Mini-DP-Schnittstelle oder eine Netzwerkschnittstelle.

11. Umschaltbare steckbare Doppel-Schnittstellen-Stromquelle und Daten-Dockingstation (10) nach einem der Ansprüche 2 bis 6, **dadurch gekennzeichnet, dass** der Typ der USB-Schnittstelle USB2.0, USB3.0, USB-C oder USB3.1 ist.

12. Umschaltbare steckbare Doppel-Schnittstellen-Stromquelle und Daten-Dockingstation (10) nach einem der Ansprüche 1 bis 6, **dadurch gekennzeichnet, dass** die erste Typ-C-Stiftschnittstelle (131), die zweite Typ-C-Stiftschnittstelle (132), die erste Typ-C-Stiftschnittstelle und die zweite Typ-C-Stiftschnittstelle alle in bidirektionaler Übertragung sind.

## Revendications

1. Station d'accueil de données et de source d'alimentation enfichable, réversible à double interface (10), comprenant un boîtier (12) ayant une cavité intérieure et une carte de circuit imprimé (12) agencée dans la cavité intérieure, dans laquelle la carte de circuit imprimé (12) est pourvue d'un premier côté et d'un second côté opposé ou adjacent au premier côté ; le premier côté est pourvu d'une première interface mâle de type C (131) configurée pour être connectée à une première interface d'un MacBook Pro, et d'une seconde interface mâle de type C (132) qui est agencée côte à côte à un intervalle de la première interface mâle de type C (131) et configurée pour être connectée à une seconde interface, adjacente à la première interface, du MacBook Pro ; le second côté est pourvu d'une première interface femelle de type C (141) et d'une seconde interface femelle de type C (142) qui sont respectivement opposées à la première interface mâle de type C et à la seconde interface mâle de type C (132), et le second côté est en outre pourvu d'un groupe d'interfaces (15) pour le chargement et/ou pour la transmission de données pour un produit électronique externe ; la première interface mâle de type C et la seconde interface mâle de type C sont exposées à l'extérieur du boîtier (12) ; et le boîtier est pourvu d'une pluralité d'ouvertures (16) correspondant respectivement à la première interface femelle de type C, à la seconde interface femelle de type C et au groupe d'interfaces (15) sur une base de correspondance biunivoque,
dans laquelle, en outre, la première interface femelle de type C (141) est connectée à un dispositif avec des interfaces de type C et configurée pour prendre en charge une transmission de données USB, et la seconde interface femelle de type C (142) est connectée au dispositif avec des interfaces de type C et configurée pour prendre en charge une fonction de chargement PD.

2. Station d'accueil de données et de source d'alimentation enfichable, réversible à double interface (10) selon la revendication 1, **caractérisée en ce que** le groupe d'interfaces (15) comprend une interface USB, une interface HDMI configurée pour être connectée à un dispositif d'affichage, une interface de carte SD pour lire une carte SD, et une interface de carte Micro SD pour lire une carte Micro SD.

3. Station d'accueil de données et de source d'alimentation enfichable, réversible à double interface (10) selon la revendication 1, **caractérisée en ce que** le boîtier (12) comprend un boîtier de dessous (111), qui comprend une portion de dessous et une paroi latérale s'étendant le long de la périphérie de la portion de dessous, dans laquelle la portion de dessous et la paroi latérale sont closes pour former la cavité intérieure, une extrémité supérieure de la paroi latérale est connectée de façon amovible à un couvercle supérieur (112), et les ouvertures (16) sont prévues dans la paroi latérale.

4. Station d'accueil de données et de source d'alimentation enfichable, réversible à double interface (10) selon la revendication 3, **caractérisée en ce qu'**un cadre de fixation (17) est agencé dans la cavité intérieure, et la carte de circuit imprimé (12) est installée sur le cadre de fixation.

5. Station d'accueil de données et de source d'alimentation enfichable, réversible à double interface (10) selon la revendication 4, **caractérisée en ce que** le cadre de fixation (17) comprend une plaque de dessous et une paroi de cadre latérale s'étendant le long de la périphérie de la plaque de dessous, dans laquelle la paroi de cadre latérale est pourvue d'une pluralité d'encoches (171) correspondant respectivement à l'ouverture (16) sur une base de correspondance biunivoque, et la carte de circuit imprimé (12) est installée dans un espace clos par la plaque de dessous et la paroi de cadre latérale.

6. Station d'accueil de données et de source d'alimentation enfichable, réversible à double interface (10) selon la revendication 5, **caractérisée en ce que** la périphérie du couvercle supérieur (112) est pourvue d'une pluralité d'ardillons (1121) agencés à des intervalles, et la paroi de cadre latérale est pourvue d'une pluralité de fentes d'ardillon (172) correspondant respectivement aux ardillons (1121) et concordant avec ceux-ci sur une base de correspondance biunivoque.

7. Station d'accueil de données et de source d'alimentation enfichable, réversible à double interface (10) selon l'une quelconque des revendications 2 à 6, **caractérisée en ce que** le nombre des interfaces USB est fixé à au moins un.

8. Station d'accueil de données et de source d'alimentation enfichable, réversible à double interface (10) selon l'une quelconque des revendications 1 à 6, **caractérisée en ce que** le boîtier (12) présente une forme allongée.

9. Station d'accueil de données et de source d'alimentation enfichable, réversible à double interface (10) selon l'une quelconque des revendications 1 à 6, **caractérisée en ce qu'**une puce de commande principale, une puce de décodage haute définition, une puce de gestion de source d'alimentation, un transformateur haute fréquence et un composant d'alimentation sont agencés à des intervalles sur la carte de circuit imprimé (12).

10. Station d'accueil de données et de source d'alimentation enfichable, réversible à double interface (10) selon l'une quelconque des revendications 1 à 6, **caractérisée en ce que** le groupe d'interfaces (15) comprend en outre une interface VGA, une interface DVI, une interface DP, une interface Mini DP ou une interface réseau.

11. Station d'accueil de données et de source d'alimentation enfichable, réversible à double interface (10) selon l'une quelconque des revendications 2 à 6, **caractérisée en ce que** le type de l'interface USB est USB2.0, USB3.0, USB-C ou USB3.1.

12. Station d'accueil de données et de source d'alimentation enfichable, réversible à double interface (10) selon l'une quelconque des revendications 1 à 6, **caractérisée en ce que** la première interface mâle de type C (131), la seconde interface mâle de type C (132), la première interface mâle de type C et la seconde interface mâle de type C sont toutes en transmission bidirectionnelle.
